# FASCICULE DE BREVET EUROPEEN

(11) **EP 2 786 426 B1**
(45) Date de publication et mention de la délivrance du brevet: **30.12.2015**
(21) Numéro de dépôt: 12790921.6
(22) Date de dépôt: 27.11.2012
(51) Int. Cl.: H01L 31/103, H01L 31/18

(54) **STRUCTURE SEMICONDUCTRICE APTE A RECEVOIR UN RAYONNEMENT ÉLECTROMAGNÉTIQUE, COMPOSANT SEMICONDUCTEUR ET PROCÉDÉ DE FABRICATION D'UNE TELLE STRUCTURE SEMICONDUCTRICE**
HALBLEITERSTRUKTUR ZUR AUFNAHME VON ELEKTROMAGNETISCHER STRAHLUNG, HALBLEITERBAUELEMENT UND VERFAHREN ZUR HERSTELLUNG EINER SOLCHEN HALBLEITERSTRUKTUR
SEMICONDUCTOR STRUCTURE ABLE TO RECEIVE ELECTROMAGNETIC RADIATION, SEMICONDUCTOR COMPONENT AND PROCESS FOR FABRICATING SUCH A SEMICONDUCTOR STRUCTURE

(30) Priorité: 29.11.2011 FR 1160900
(43) Date de publication de la demande: 08.10.2014
(73) Titulaire: Commissariat à l'Énergie Atomique et aux Énergies Alternatives, 75015 Paris (FR)
(72) Inventeur: GRAVRAND, Olivier, F-38120 Fontanil Cornillon (FR); DESTEFANIS, Gérard, F-38120 Saint-Egreve (FR)
(74) Mandataire: Ahner, Philippe
(86) Numéro de dépôt international: PCT/EP2012/073710
(87) Numéro de publication internationale: WO 2013/079475

(56) Documents cités:
- WO-A1-2010/140621
- US-A- 4 875 084
- US-A1- 2003 227 064
- F. X. ZHA ET AL: "The blue-shift effect of the ion-milling-formed HgCdTe photodiodes", PROCEEDINGS OF SPIE, vol. 6984, 1 janvier 2008 (2008-01-01), pages 69840G-69840G-4, XP055039157, ISSN: 0277-786X, DOI: 10.1117/12.792273
- I. M. BAKER ET AL: "Summary of HgCdTe 2D array technology in the U.K.", JOURNAL OF ELECTRONIC MATERIALS, vol. 30, no. 6, 1 juin 2001 (2001-06-01), pages 682-689, XP055039154, ISSN: 0381-5235, DOI: 10.1007/BF02665856

## Description

### DOMAINE TECHNIQUE

L'invention se rapporte au domaine de la détection et/ou de la mesure de rayonnements électromagnétiques et aux dispositifs permettant une telle détection et/ou mesure.

L'évolution rapide de l'optoélectronique liée à l'adaptation des technologies de la micro-électronique au semiconducteur à gap direct a permis la mise en place de dispositifs permettant la mesure et/ou la détection de rayonnements électromagnétiques compacts, ceci dans des gammes de longueurs d'ondes allant des ultra-violets aux infrarouges.

Ces dispositifs mettent généralement en oeuvre des structures semiconductrices aptes à recevoir un rayonnement électromagnétique et à le transformer en un signal électrique.

L'invention se rapporte plus particulièrement à une structure semiconductrice apte à recevoir un rayonnement électromagnétique et à le transformer en un signal électrique, à un composant semiconducteur comportant au moins une telle structure semiconductrice et à un procédé de fabrication d'une telle structure semiconductrice.

### ÉTAT DE LA TECHNIQUE ANTÉRIEURE

Les structures semiconductrices aptes à recevoir un rayonnement électromagnétique et à le transformer en un signal électrique comprennent généralement un support semiconducteur dans lequel sont ménagées une première et une seconde zone en contact l'une de l'autre et présentant respectivement un premier et un second type de conductivité inverse l'un de l'autre. De cette manière la première et la seconde zone forment ensemble, au niveau de leur contact, une jonction semiconductrice.

Ainsi, pour un support dont le matériau semiconducteur est un matériau semiconducteur à gap direct et une polarisation inverse de la jonction, lorsqu'un photon, ayant une énergie supérieure à celle de la bande interdite du matériau semiconducteur, pénètre la jonction semiconductrice, celui-ci va générer une paire électron-trou et donc un courant dans la jonction. Ce courant, étant directement proportionnel au rayonnement électromagnétique, fournit une mesure de ce même rayonnement électromagnétique.

On entend par matériau semiconducteur à gap direct un matériau semiconducteur dont le maximum d'énergie de la bande de valence et le minimum d'énergie de la bande de conduction se situent à une valeur du vecteur d'onde k sensiblement égale dans le diagramme de dispersion énergétique dudit matériau semiconducteur.

Si une telle technologie est bien adaptée pour la détection et la mesure de rayonnements électromagnétiques dans la gamme de longueur d'onde du visible, elle présente un certain nombre de limitations pour une utilisation dédiée à la mesure de rayonnements électromagnétiques dont la longueur d'onde est comprise dans la gamme des infrarouges. En effet, pour la détection d'un tel rayonnement, l'énergie de la bande interdite doit être inférieure à celle du rayonnement électromagnétique à détecter, c'est-à-dire pour une longueur d'onde de 5 µm, inférieure à 250 meV. Cette faible énergie de la bande interdite s'approche de l'énergie correspondant à l'agitation thermique à la température ambiante qui est d'environ 25 meV.

Il en résulte donc qu'une structure adaptée pour la détection de rayonnements électromagnétiques dans la gamme de longueur d'onde des infrarouges présente, lorsqu'elle est utilisée à la température ambiante, un courant d'obscurité, c'est-à-dire un courant de jonction en l'absence de tout rayonnement électromagnétique, de forte valeur, ce courant ayant pour origine la génération de paires électron-trou liée à l'agitation thermique ceci notamment en raison du phénomène de recombinaison Auger. Ce courant d'obscurité influençant directement le rapport signal sur bruit de la structure et donc la sensibilité de la structure, doit être abaissé. Cela est généralement réalisé par un maintien de la structure semiconductrice, pendant son fonctionnement, à une température basse, typique inférieure à -150°C.

Une autre limitation de telles structures est la diaphonie entre les structures d'un même composant. En effet, en raison d'une forte longueur de diffusion des porteurs minoritaires, supérieure au micromètre, les structures peuvent interagir entre elles réduisant ainsi la résolution spatiale du composant.

Lorsque le support de la structure est choisi comme étant transparent au rayonnement électromagnétique à détecter et/ou à mesurer, le courant d'obscurité a pour principale origine les zones en périphérie de la jonction qui sont donc latérales par rapport à la surface du support.

Pour réduire le courant d'obscurité ayant pour origine la diffusion latérale des porteurs minoritaires principalement générés par le phénomène de recombinaison Auger à la périphérie de la jonction, il est connu de l'enseignement fourni par Jozwikowsky [1] et par Schaake [2], de réaliser la jonction au sein d'une mésa [1], ou d'une structure dont les dimensions latérales sont limitées dans l'espace [2]. Ainsi, dans le cas d'une mesa par exemple, la périphérie de la jonction est rendue isolante par la présence d'une couche d'air, supprimant toute possibilité de création de paires électron-trou dans cette zone périphérique.

De plus, la zone centrale dans laquelle s'effectue la photo-génération est généralement déplétée de tous porteurs libres sous l'action d'une différence de potentiel à ses bornes. La recombinaison Auger étant un phénomène à plusieurs porteurs, l'absence de porteurs libres supprime alors cette source de recombinaison dans la zone centrale, diminuant ainsi le courant d'obscurité de la jonction résultante.

Néanmoins, si une telle méthode permet de supprimer toute possibilité de génération de paires électron-trou thermiques, et notamment Auger, dans la zone périphérique mais aussi dans la zone centrale, elle nécessite des opérations de passivation des flancs de mésa et/ou de la structure, afin de limiter le courant d'obscurité ayant pour origine l'interface semiconducteur-air. Ces opérations, en raison de l'orientation des flancs, restent difficiles et généralement coûteuses à mettre en oeuvre.

### EXPOSÉ DE L'INVENTION

La présente invention vise à remédier à ces inconvénients.

Un des buts de l'invention est la fourniture d'une structure semiconductrice apte à recevoir un rayonnement électromagnétique et à le transformer en un signal électrique qui, lorsqu'elle est adaptée pour recevoir un rayonnement électromagnétique dont la longueur d'onde est dans la gamme des infrarouges, présente un faible courant d'obscurité à la température ambiante vis-à-vis d'une structure semiconductrice de l'art antérieur et qui, lorsqu'elle est mise en oeuvre au travers d'un composant comportant une pluralité de structures semiconductrices, ne présente pas un phénomène de diaphonie important, ceci sans nécessiter d'opération de gravure et de passivation des flancs de gravure pour former au moins une partie du moyen de limitation du courant latéral.

Un autre but de l'invention est de fournir une structure semiconductrice adaptée pour fonctionner avec un système de concentration du rayonnement électromagnétique disposé en regard de la première surface du support.

A cet effet, l'invention concerne une structure semiconductrice apte à recevoir un rayonnement électromagnétique et à le transformer en un signal électrique, une telle structure semiconductrice comportant :
- un support semiconducteur présentant une première et une seconde surface, la première surface définissant un plan longitudinal,
- une première zone d'un premier type de conductivité ménagée dans le support,
- une deuxième zone d'un deuxième type de conductivité, inverse du premier type de conductivité, la deuxième zone étant ménagée dans le support en contact de la première zone de manière à former avec la première zone une jonction semiconductrice,
- un moyen de limitation du courant latéral adapté pour limiter le courant de la jonction dont l'origine est latérale au plan longitudinal, ledit moyen de limitation du courant latéral entourant au moins partiellement la jonction,

Le moyen de limitation du courant latéral comportant une troisième zone ménagée dans le support en contact latéral avec la deuxième zone, ladite troisième zone étant du deuxième type de conductivité, le deuxième type de conductivité étant une conductivité dont les porteurs majoritaires sont des électrons, la troisième zone présentant une concentration en porteurs majoritaires suffisante pour présenter une augmentation du gap apparent en raison d'un effet Moss-Burstein.

On entend ci-dessus et dans le reste de ce document par « concentration en porteur majoritaires suffisante pour présenter une augmentation du gap apparent en raison d'un effet Moss-Burstein » que la concentration en porteur majoritaire est telle que l'énergie du niveau de Fermi Ef est supérieure à l'énergie du bas de la bande de conduction.

On entend ci-dessus et dans le reste de ce document par « deuxième type de conductivité, inverse du premier type de conductivité », que les porteurs majoritaires du deuxième type de conductivité présentent une charge électrique opposée à celle des porteurs majoritaires du premier type de conductivité.

Une telle troisième zone de par sa forte concentration en porteurs majoritaires nécessaire pour obtenir un effet Moss-Burstein, présente une faible concentration en porteurs minoritaires. Ainsi, la génération de paires électron-trou thermiques, notamment celle ayant pour origine la recombinaison Auger, voyant sa probabilité réduite, s'en trouve fortement contenue. Cette même troisième zone, ne présentant pas de paires électron-trou photogénérées à la longueur d'onde à détecter et/ou mesurer, le gap apparent étant augmenté vis-à-vis du matériau formant la jonction, il n'y a pas de possibilité de création, dans cette troisième zone de courant parasite qui pourrait générer du signal dans une autre structure. La diaphonie s'en trouve donc également réduite.

Le premier type de conductivité peut être un type de conductivité pour lequel les porteurs majoritaires sont des trous, le deuxième type de conductivité étant alors un type de conductivité pour lequel les porteurs majoritaires sont des trous.

La structure semiconductrice est préférentiellement une structure semiconductrice adaptée pour la mesure et/ou la détection de rayonnements électromagnétiques dans la gamme des infrarouges, cette adaptation étant préférentiellement obtenue en réalisant la deuxième zone dans un matériau présentant une énergie de bande interdite inférieure à 0,85 eV.

De plus, l'effet Moss-Burstein ayant pour effet d'augmenter le gap apparent du matériau formant la troisième zone, le rayonnement électromagnétique à détecter passant à travers la troisième zone peut être dirigé vers un système de concentration du rayonnement électromagnétique adapté pour renvoyer ce rayonnement sur la jonction et ainsi augmenter le rapport signal sur bruit.

La troisième zone peut être en contact avec la deuxième zone sur toute l'épaisseur de la deuxième zone.

La troisième zone peut entourer la jonction. Ainsi la troisième zone permet de limiter le courant d'obscurité d'origine latérale sur tout le pourtour de la jonction.

Il peut en outre être prévu une quatrième zone en contact avec la première zone du même type de conductivité que la première zone, la quatrième zone présentant une concentration en porteurs majoritaires supérieure à celle de la première zone.

Avec une telle quatrième zone, offrant un moyen de polarisation de la première zone, la concentration en porteurs majoritaires de la première zone peut être réduite pour permettre la formation, avec la deuxième zone, d'une jonction étendue et moins abrupte, idéale pour la détection d'un rayonnement électromagnétique. La deuxième zone peut entourer la première zone, la troisième entourant la deuxième zone.

Une telle configuration permet d'avoir une jonction de type planaire, c'est-à-dire présentant une surface plane.

La première zone et la deuxième zone sont en contact selon un plan de jonction sensiblement longitudinal.

La première zone et la deuxième zone sont dans des plans longitudinaux sensiblement différents, le contact de la première zone sur la seconde zone étant réalisé selon un plan de jonction sensiblement longitudinal.

De cette manière, la jonction est présente sur un plan sensiblement longitudinal sur une surface qui peut être équivalente à celle de la première zone.

Les première, deuxième et troisième zones sont ménagées dans une couche du support qui est dite active, la couche active comportant la première surface du support semiconducteur et la première zone étant à distance de la face de la couche active opposée à la première surface du support semiconducteur, la structure semiconductrice comportant en outre une couche dite de confinement, ménagée dans le support semiconducteur en contact longitudinal avec la couche active sur une face de la couche active opposée à la première surface du support semiconducteur, ladite couche de confinement présentant le deuxième type de conductivité, la couche de confinement présentant une concentration en porteurs majoritaires suffisante pour présenter une augmentation du gap apparent en raison d'un effet Moss Burstein.

Une telle couche de confinement permet de limiter le courant d'obscurité qui a pour origine la partie du support qui est sous la couche active. De plus cette couche de confinement, en étant à l'interface entre le substrat et la couche active, permet, lorsqu'elle est réalisée dans un matériau similaire à celle de la couche active, de faire une adaptation du paramètre de maille et de réduire les risques de défauts cristallins dans la couche active. La structure peut comprendre un moyen de polarisation électrique de la première zone, ledit moyen de polarisation étant ménagé sur la première surface, la deuxième surface étant adaptée pour recevoir le rayonnement électromagnétique.

Un tel moyen de polarisation permet de polariser la jonction sur la première surface sans interaction avec le rayonnement électromagnétique à détecter, celui-ci étant reçu sur la deuxième surface.

La première et la deuxième zone peuvent chacune être réalisées dans un matériau semiconducteur différent de celui de l'autre zone de la première et de la deuxième zone de manière à ce que la structure forme une hétérostructure.

Une telle configuration permet à la première et à la deuxième zone de présenter une largeur de bande interdite différente l'une de l'autre, offrant ainsi la possibilité, si l'une des zones de la première et de la deuxième zone n'est pas destinée à recevoir le rayonnement électromagnétique, d'augmenter la largeur de bande interdite afin de limiter le courant d'obscurité généré dans ladite zone.

Au moins l'une des zones de la première, la deuxième et la troisième zone peut être réalisée dans un matériau semiconducteur sélectionné parmi l'InSb et les semiconducteurs du type InAs₁₋ₓSbₓ, InAl₁₋ₓSbₓ et CdₓHg₁₋ₓTe, avec x compris entre 0 et 1.

De tels matériaux présentent un gap direct avec une largeur de bande interdite adaptée pour la détection de rayonnements électromagnétiques dans l'infrarouge.

L'invention se rapporte également à un composant semiconducteur comportant un support semiconducteur sur lequel sont ménagées une pluralité de structures semiconductrices, au moins une des structures semiconductrices étant une structure semiconductrice selon l'invention.

Un tel composant semiconducteur présente, pour au moins l'une des structures semiconductrices ménagées dans son support, celle ou celles selon l'invention, un courant d'obscurité de faible intensité, lorsque la ou lesdites structures semiconductrices sont adaptées pour détecter et/ou mesurer un rayonnement électromagnétique dans la gamme des infrarouges, et une diaphonie réduite pour cette ou ces mêmes structures semiconductrices.

L'ensemble des structures semiconductrices peuvent être des structures semiconductrices selon l'invention, les troisièmes zones des structures étant en contact les unes avec les autres.

Un tel contact entre les troisièmes zones des structures semiconductrices permet de polariser les deuxièmes zones des structures au moyen d'un seul contact pris sur au moins l'une des troisièmes zones, ces troisièmes zones présentant une forte conductivité en raison de la forte concentration en porteurs majoritaires nécessaire pour obtenir l'effet Moss-Burstein.

Il peut être en outre prévu un moyen de concentration de rayonnements électromagnétiques adapté pour concentrer le rayonnement électromagnétique reçu par le composant semiconducteur sur la jonction semiconductrice, ledit moyen étant préférentiellement agencé dans le composant semiconducteur en regard de la première surface du support semiconducteur.

Un tel moyen de concentration du rayonnement électromagnétique permet de concentrer le rayonnement électromagnétique reçu par une partie du composant sur la jonction d'une des structures semiconductrices. L'augmentation du flux de rayonnement électromagnétique sur la jonction permet d'augmenter le signal lié à la mesure, limitant ainsi l'influence du courant d'obscurité.

L'invention concerne également un procédé de fabrication d'une structure semiconductrice, ledit procédé étant adapté pour la fabrication d'une structure semiconductrice selon l'invention, ledit procédé comprenant les étapes consistant à :
- fournir un support semiconducteur,
- former une première zone d'un premier type de conductivité dans le support semiconducteur,
- former une deuxième zone d'un second type de conductivité, dont les porteurs majoritaires sont des électrons, dans le support en contact avec la première zone de manière à former une jonction semiconductrice,
- former une troisième zone du second type de conductivité, en contact latéral avec la deuxième zone, la concentration de ladite troisième zone étant suffisante pour présenter un effet Moss Burstein, ladite troisième zone entourant au moins partiellement la jonction semiconductrice.

Le procédé peut être adapté pour réaliser une structure semiconductrice dans laquelle la deuxième zone entoure la première zone, la troisième zone entourant la deuxième zone, les étapes de formation de la première et de la deuxième zone étant réalisées simultanément en formant la première zone dans une couche du support présentant la concentration du type de la deuxième zone.

Le procédé peut être adapté pour la formation d'une structure semiconductrice dans laquelle la première zone et la deuxième zone sont dans des plans longitudinaux sensiblement différents, le contact de la première zone sur la seconde zone étant réalisé selon un plan de jonction sensiblement longitudinal, l'étape de formation de la première couche comportant une étape de gravure d'une couche de formation de la première couche en contact avec la portion de la deuxième couche de manière à former la jonction semiconductrice.

Un tel procédé permet la fabrication d'une structure semiconductrice présentant, lorsqu'elle est adaptée pour la détection et/ou la mesure d'un rayonnement électromagnétique dans la gamme des infrarouges, un faible courant d'obscurité et, pour une structure semiconductrice dont le support comporte plusieurs structures semiconductrices, une faible diaphonie avec les structures semiconductices voisines.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre schématiquement une coupe d'une structure selon un premier mode de réalisation de l'invention, la structure semiconductrice étant de révolution autour de l'axe A-A,
- les figures 2a et 2b illustrent schématiquement le phénomène Moss-Burstein, la figure 2a illustrant le phénomène de création d'une paire électron-trou avec un matériau semiconducteur ne présentant pas d'effet Moss-Burstein et la figure 2b illustrant ce même phénomène pour un matériau présentant un effet Moss-Burstein,
- le figure 3 illustre un composant comportant 4 structures telles que celle illustrée sur la figure 1,
- la figure 4 illustre schématiquement une coupe d'une structure selon un deuxième mode de réalisation de l'invention dans lequel la première zone et la deuxième zone sont dans des plans différents, la jonction étant parallèle au plan de la surface du support, la structure semiconductrice étant de révolution autour de l'axe B-B,
- la figure 5 illustre schématiquement une coupe d'une structure selon un troisième mode de réalisation dans lequel la première et la deuxième zone sont en contact latéral et longitudinal et dans lequel il est en outre prévu une couche de confinement.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

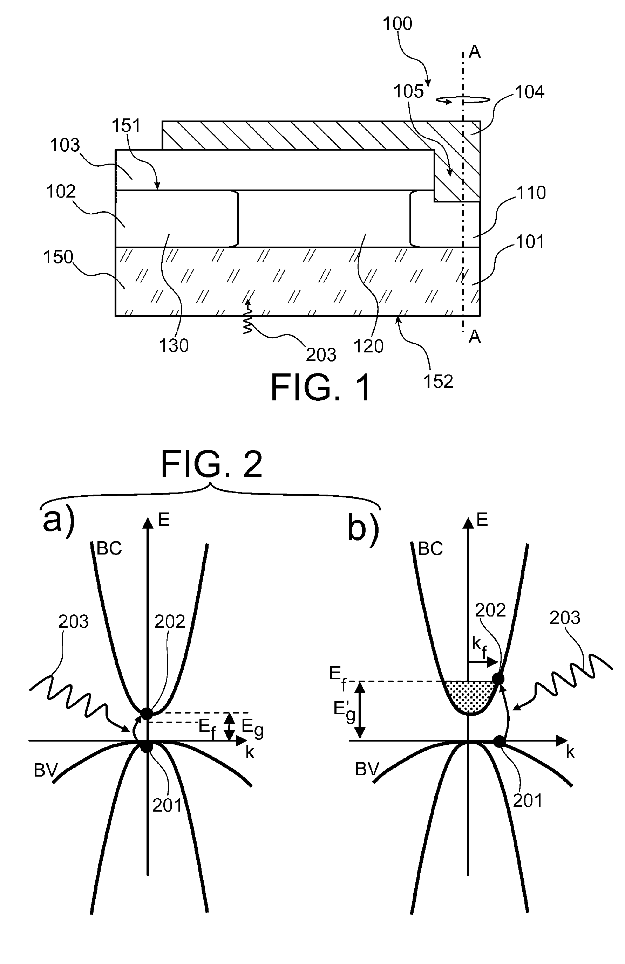

La figure 1 illustre un premier mode de réalisation d'une structure semiconductrice 100 apte à recevoir un recevoir un rayonnement électromagnétique et à le transformer en un signal électrique.

Une telle structure fait appel à l'effet Moss-Burstein afin de limiter le courant d'obscurité de la structure.

Les figures 2a et b, illustrent schématiquement la création d'une paire électron-trou 202-201 dans respectivement un matériau semiconducteur ne présentant pas un tel effet Moss-Burstein et un matériau semiconducteur présentant ledit effet, les deux matériaux étant des matériaux semiconducteurs à gap direct.

Ainsi, la figure 2a illustre schématiquement la répartition des niveaux énergétiques pour un matériau semiconducteur présentant une conductivité dont les porteurs majoritaires sont des électrons 202 et dont la concentration en porteurs majoritaires est telle que l'énergie de Fermi Ef est présente dans la bande interdite du matériau semiconducteur. Pour un tel matériau, un photon 203, dont l'énergie est légèrement supérieure à celle de la bande interdite Eg, peut venir, comme illustré sur la figure 2a exciter un électron 202 pour le faire passer de la bande de valence BV à la bande de conduction BC et ainsi créer une paire électron-trou 202-201. Cette paire électron-trou 202-201, pour une jonction semiconductrice polarisée en inverse, vient s'ajouter au courant de la jonction indiquant la détection d'un photon 203 dont l'énergie est au moins égale à celle correspondant à la bande interdite.

Pour la figure 2b, le matériau semiconducteur est un matériau semiconducteur dont la conductivité est telle que l'énergie de Fermi Ef est dans la bande de conduction BC. Avec une telle conductivité, le matériau semiconducteur est dit dégénéré, c'est-à-dire qu'il présente un comportement électrique similaire à celui d'un matériau métallique.

Dans une telle configuration, comme illustré sur la figure 2b, la bande de conduction peut être, selon une première approximation, considérée comme peuplée jusqu'à l'énergie de Fermi Ef. Ainsi, un électron 202 susceptible d'être excité par un photon 203, dont l'énergie est du même ordre que celle de la bande interdite Eg, ne sera pas à même d'atteindre le bas de la bande de conduction BC, le bas de la bande de conduction BC étant déjà occupé. Pour générer une paire électron-trou 202-201 dans un tel matériau semiconducteur, il est donc nécessaire que l'énergie transmise par le photon 203 à l'électron 202 soit au moins égale à l'énergie de Fermi Ef à laquelle on aura soustrait celle du sommet de la bande de valence BV.

Il en résulte donc qu'un matériau semiconducteur présentant un phénomène de Moss-Burstein est transparent au rayonnement électromagnétique dont la longueur d'onde correspond à l'énergie Eg de la bande interdite et est apte à absorber les rayonnements électromagnétiques dont la longueur d'onde correspond à une énergie supérieure à l'énergie de Fermi Ef à laquelle on aura soustrait celle du sommet de la bande de valence BV. Ainsi, la valeur d'énergie correspondant à l'énergie de Fermi Ef à laquelle on aura soustrait celle du sommet de la bande de valence EV est l'énergie du gap optique apparent Eg' à partir de laquelle le matériau devient absorbant pour le rayonnement électromagnétique.

De même, un matériau semiconducteur présentant un tel effet Moss-Burstein est, comme indiqué ci-dessus, un matériau semiconducteur dégénéré, c'est-à-dire possédant une forte concentration en porteurs majoritaires et donc une faible concentration en porteurs minoritaires. La présence d'un gap optique apparent, augmentant l'énergie nécessaire pour générer une paire électron-trou 202-201 en combinaison avec une faible concentration de porteurs minoritaires, diminue fortement la génération thermique de paires électron-trou 202-201 dans le matériau semiconducteur et donc du courant d'obscurité.

La structure semiconductrice 100, illustrée figure 1, fait appel à cet effet Moss-Burstein pour réduire le courant d'obscurité dans la structure semiconductrice 100 et fournir une structure semiconductrice 100, apte à recevoir un rayonnement électromagnétique et à le transformer en un signal électrique, possédant une sensibilité peu affectée par le courant d'obscurité à la température ambiante.

Une telle structure semiconductrice 100 comporte :
- un support 150 semiconducteur présentant une première et une seconde surface 151, 152, la première surface 151 définissant un plan longitudinal, Le support présente une première couche 101, dite substrat et une couche dite active 102,
- une première zone 110 d'un premier type de conductivité ménagée dans la couche active 102,
- une deuxième zone 120 d'un deuxième type de conductivité, inverse du premier type de conductivité, la deuxième zone étant ménagée dans la couche active 102 en contact de la première zone 110 de manière former avec la première zone 110 une jonction semiconductrice,
- une troisième zone 130 du deuxième type de conductivité dont la conductivité est telle que le matériau semiconducteur de la troisième zone 130 présente un effet Moss-Burstein, ladite troisième étant ménagée dans la couche active 102,
- une couche de passivation 103, et
- un plot de polarisation 104 en contact électrique avec la première zone 110.

La structure semiconductrice 100 est, comme illustré sur la figure 1, une structure semiconductrice présentant une symétrie de révolution autour d'un axe de révolution A-A.

Le support 150 est un support en matériau semiconducteur présentant une forme sensiblement plane. Le support 150 présente une première surface 151 destinée à la connexion électrique de la structure semiconductrice 100 et une seconde surface 152, opposée à la première surface 151 destinée à recevoir le rayonnement électromagnétique à détecter et/ou à mesurer.

Le support 150 présente la première couche 101 qui est dite substrat, réalisée préférentiellement dans un matériau diélectrique isolant ou semiconducteur adapté pour produire un faible courant d'obscurité et choisi comme étant transparent aux longueurs d'ondes du rayonnement à détecter. Le substrat 101 présente un accord de maille suffisant avec les matériaux composant la couche active 102 de manière à limiter les défauts cristallins présents dans la première et la deuxième zone 110, 120 qui y sont ménagées.

Ainsi, le substrat 101 peut être, pour une structure adaptée pour la mesure et/ou la détection de rayonnements électromagnétiques dans la gamme des infrarouges, réalisé en tellurure de cadmium et zinc CdZnTe. Ce matériau semiconducteur CdZnTe présente une énergie de bande interdite d'au moins 1,4 eV, et est donc transparent aux infrarouges et peu sensible au bruit thermique. Le substrat, selon cette même possibilité, peut également être en tellurure de cadmium CdTe.

Le substrat 101 présente une forme sensiblement plane, avec une première face formant la deuxième surface 152 du support et une seconde face opposée à la première face.

Dans le cas où le substrat 101 est du tellurure de cadmium et zinc, la concentration en porteurs majoritaires est préférentiellement choisie faible.

Le support 150 comporte également, en contact avec le substrat 101 sur sa seconde face, la couche active 102. Cette couche active 102, est réalisée dans un matériau semiconducteur dont l'énergie de la bande interdite est adaptée pour la détection et/ou la mesure du rayonnement électromagnétique à détecter et/ou mesurer.

La couche active 102 peut être réalisée, pour un rayonnement électromagnétique à détecter dans la gamme des infrarouges, dans un matériau semiconducteur, tel qu'un alliage du type CdₓHg₁₋ₓTe, avec x choisi entre 0 et 1 en fonction de la longueur d'onde du rayonnement à détecter.

La première, la deuxième et la troisième zone 110, 120, 130 sont ménagées dans la couche active 102. Cet aménagement de la première, de la deuxième et de la troisième zone 110, 120, 130 est réalisé par rapport à l'axe de révolution A-A de manière à ce que ces trois zones 110, 120, 130 soient concentriques les unes par rapport aux autres.

La première zone 110 est la zone centrale de la structure 100 réalisée autour de l'axe de révolution A-A. La première zone 110 présente une conductivité dont les porteurs majoritaires sont des trous 201. La concentration en porteurs majoritaires de la première zone 101 est préférentiellement importante pour permettre une polarisation électrique de la première zone 110 en présentant une faible résistance d'entrée.

Dans le cas où la couche active 102 est réalisée dans un matériau semiconducteur du type CdₓHg₁₋ₓTe, la conductivité de la première zone 110 peut être définie par un dopage de cette première zone 110 à l'arsenic As.

La deuxième zone 120 est une zone en contact latéral avec la première zone 110. La deuxième zone 120 présente une conductivité telle que les porteurs majoritaires de la deuxième zone 120 sont des électrons 202. Ainsi la première zone 110 possédant de faibles dimensions par rapport à la deuxième zone 120, celle-ci présente une forte concentration en porteurs majoritaires, de l'ordre de 10¹⁷ cm⁻³ ou supérieure. La deuxième zone 120, elle, présente une concentration en porteurs majoritaires plus faible, de l'ordre de 10¹⁵ cm⁻³ préférentiellement comprise entre 5.10¹⁴ et 10¹⁶. cm⁻³. La concentration de la deuxième zone 120 en porteurs majoritaires peut être obtenue, par exemple, lorsque le matériau de la couche active 102 est un alliage du type CdₓHg₁₋ₓTe, par un dopage à l'indium In.

La deuxième zone 120 entoure la première zone 110. Le contact entre la première zone 110 et la deuxième zone 120 est sensiblement latéral.

La première et la deuxième zone 110, 120 forment ensemble au niveau de leur contact une jonction semiconductrice. La jonction semiconductrice, en raison des différences de concentrations en porteurs majoritaires de la première et la deuxième zone 110, 120, est une jonction asymétrique. La concentration en porteurs majoritaires étant plus faible dans la deuxième zone 120 par rapport à la première zone 110, la zone de charge d'espace s'étend principalement du coté le moins dopé, ie sur la deuxième zone 120.

Ainsi, pour une polarisation inverse de la jonction semiconductrice, la génération de paires électron-trou 202-201 dans la jonction a principalement lieu dans la deuxième zone 120.

La troisième zone 130 entoure la deuxième zone 120. La troisième zone 130 est une zone dont la conductivité est telle que les porteurs majoritaires de la troisième zone 130 sont des électrons 202. La troisième zone 130 présente une concentration en porteurs majoritaires suffisante pour que le matériau semiconducteur la composant présente un effet Moss-Burstein. Dans le cas où la couche active 102 est un alliage du type CdₓHg₁₋ₓTe, la concentration en porteurs majoritaires de la troisième zone 130 doit être supérieure à 10¹⁷ cm⁻³ pour présenter l'effet Moss-Burstein.

La troisième zone est en contact avec la deuxième zone sur toute l'épaisseur de la deuxième zone.

Selon ce même cas, la concentration en porteurs majoritaires de la troisième zone 130 est préférentiellement supérieure à 10¹⁸ cm⁻³. Une telle concentration peut être obtenue par implantation ionique de bore dans la couche active pour une couche active formée d'un alliage du type CdₓHg₁₋ₓTe.

La troisième zone forme un moyen de limitation du courant latéral adapté pour limiter le courant de la jonction dont l'origine est latérale au plan longitudinal, ledit moyen de limitation du courant latéral entourant au moins partiellement la jonction.

La structure 100 présente, sur la face de la couche active 102 opposée à la deuxième surface 152 du support 150 une couche de passivation 103. La couche de passivation 103, pour une couche active 102 formée d'un alliage du type CdₓHg₁₋ₓTe, peut être réalisée par exemple en tellurure de cadmium CdTe et/ou en sulfure de zinc ZnS.

La couche de passivation 103 présente une ouverture 105 au niveau de la première zone 110. Cette ouverture 105 forme un accès à la première zone 110 pour permettre sa connexion au plot de polarisation 104.

Le plot de polarisation 104 est en contact avec la couche de passivation 103 sur sa face opposée à la deuxième surface 152 du support 150. Le plot de polarisation 104 est également en contact électrique avec la première zone 110 au travers de l'ouverture 105.

Le plot de polarisation 104 recouvre complètement la deuxième zone 120 et partiellement la troisième zone 103. Le plot de polarisation peut être réalisé dans un matériau conducteur offrant une faible résistance de contact avec la première zone 110.

Pour une première zone 110 réalisée dans un alliage du type CdₓHg₁₋ₓTe, le plot de polarisation 104 peut être réalisé par exemple en or Au, en titane Ti ou en chrome Cr.

La fabrication d'une telle structure 100 peut être réalisée par un procédé de fabrication comportant les étapes consistant à :
- fournir un support semiconducteur 150 comportant un substrat 101 et une couche active 102, la couche active 101 présentant une conductivité telle que les porteurs majoritaires de la couche active 101 sont des électrons 202,
- réaliser une implantation ionique de la première zone 110 dans la couche active 102,
- réaliser un recuit d'activation des ions implantés dans la première zone 110 de manière à former la première et la deuxième zone 110, 120, la deuxième zone 120 présentant la conductivité de la couche active 102 et la première zone 110 présentant une conductivité telle que les porteurs majoritaires de la première zone 110 sont des trous 201,
- déposer la couche de passivation 103 sur la couche active 102,
- réaliser l'ouverture 105 de la couche de passivation 103 au niveau de la première zone 110,
- déposer le plot de polarisation 104 sur la couche de passivation 103 avec un contact entre le plot de polarisation 104 et la première zone 110,
- réaliser une implantation ionique de la troisième zone 130 de manière à ce que la troisième zone présente une conductivité telle que les porteurs majoritaires de la troisième zone 130 sont des électrons, l'implantation de la troisième zone 130 étant réalisée de manière à ce qu'elle entoure la deuxième zone 120 en la délimitant.

Selon une alternative à ce procédé de fabrication, il également possible de réaliser une telle structure semiconductrice 100 en effectuant l'étape de dépôt de la couche de passivation 103 et de réalisation de l'ouverture 105 de la couche de passivation 103 préalablement à l'étape d'implantation ionique de la première zone 110.

Selon cette alternative, la formation de l'ouverture 105 étant obtenue au moyen d'une étape de gravure au travers d'une couche de résine insolée, cette couche de résine insolée (non illustrée) est utilisée en tant que masque dur pour l'implantation ionique. Un procédé selon cette alternative présente l'avantage de limiter le nombre d'opérations de masquage.

Une structure semiconductrice 100, telle que décrite ci-dessus, peut être intégrée au sein d'un composant semiconducteur comportant plusieurs structures semiconductrices afin de fournir un dispositif de détection et/ou de mesure d'un rayonnement électromagnétique, non illustré, capable de faire une mesure des variations spatiales du rayonnement électromagnétique.

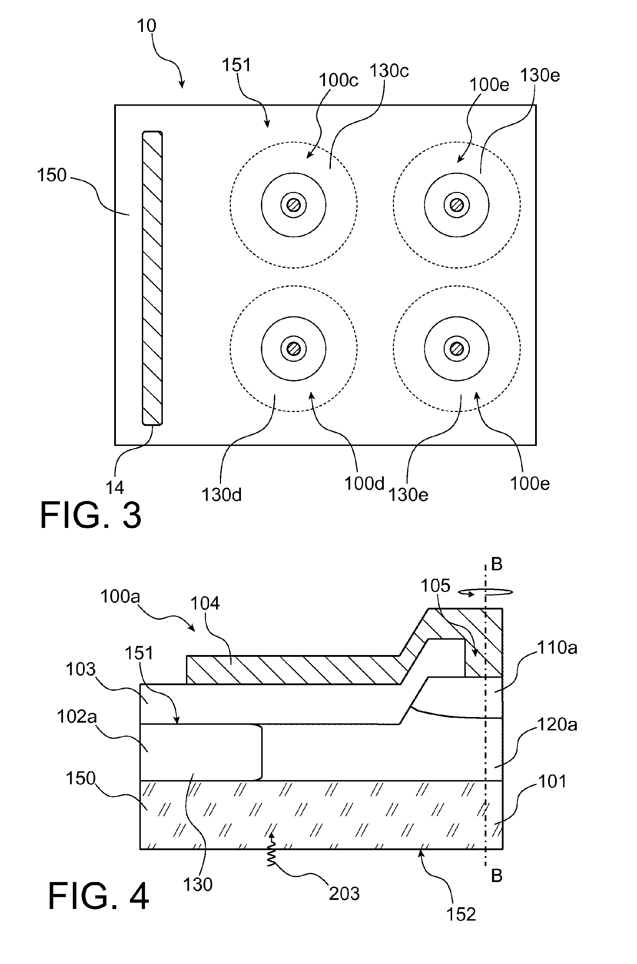

La figure 3 illustre un tel composant semiconducteur 10 comportant quatre structures semiconductrices 100c,d,e,f.

Un tel composant semiconducteur 10 présente un support commun 150 aux quatre structures semiconductrices 100c,d,e,f. Les quatres structures semiconductrices 100c,d,e,f étant réparties en colonnes et en lignes de manière à former une matrice de détection et/ou de mesure du rayonnement électromagnétique.

Les structures semiconductrices 100c,d,e,f sont en contact au moyen de leurs troisièmes zones. Il est également prévu, sur le composant semiconducteur 10, un contact électrique périphérique 14 ménagé en contact électrique avec la couche active 103 comportant les troisièmes zones des structures semiconductrices 130c,d,e,f.

Les troisièmes zones 130c,d,e,f étant des zones présentant une forte conductivité, le matériau semiconducteur les composant étant dégénéré, le seul contact électrique 14 permet de polariser chacune des troisièmes zones 130,c,d,e,f des structures semicconductrices 100,c,d,e,f.

Chacune des structures semiconductrices 100a,b,c,d peut être polarisée par le contact électrique 14 qui est commun à l'ensemble des structures semiconductrices 100c,d,e,f et par son plot métallique 105.

Une telle configuration du composant semiconducteur 10 est adaptée pour permettre l'équipement d'une électronique semiconductrice classique, telle qu'un composant en silicium, par le composant semiconducteur 10, cet équipement pouvant être réalisé par hybridation à l'indium.

En effet, les plots de polarisation 105 de chaque structures semiconductrices 100c,d,e,f étant bien séparés, puisque réalisés sur le seul plot de polarisation 105 dont la dimension est équivalente à celle de la première et/ou de la deuxième zone 110, 120 de la structure semiconductrice 100c,d,e,f correspondante, il est possible de connecter les plots de polarisation 105 aisément sans interférence du contact de la troisième zone 130 qui peut être éloigné en raison de la conductivité des troisièmes zones 130.

Selon une possibilité non illustrée, le composant peut comporter pour chacune, ou pour une partie, des structures semiconductrices 100c,d,e,f un système de concentration du rayonnement électromagnétique. Un tel système de concentration du rayonnement électromagnétique sur la structure semiconductrice 100c,d,e,f peut être disposé sur le chemin du rayonnement électromagnétique en amont de la structure semiconductrice 100c,d,e,f, ou en aval.

Dans une configuration amont, le système de concentration, tel qu'une lentille, permet de faire converger une part plus grande du rayonnement électromagnétique sur la jonction.

Dans une configuration aval, le système de concentration, tel qu'un miroir convergent, permet de récupérer la part du rayonnement électromagnétique non absorbée par la structure semiconductrice 100c,d,e,f , telle que celle passant par la troisième zone 130 rendue transparente par l'effet Moss-Burstein, et de la faire converger au niveau de la jonction semiconductrice.

Cette dernière possibilité est rendue particulièrement intéressante dans le cadre de l'invention, les dispositifs de l'art antérieur ne présentant pas de troisième zone 130 rendue transparente au moyen de l'effet Moss-Burstein.

Le système de concentration, qu'il soit amont ou aval, forme un moyen de concentration de rayonnements électromagnétiques adapté pour concentrer le rayonnement électromagnétique reçu par le composant semiconducteur sur la jonction semiconductrice.

La figure 4 illustre une structure semiconductrice 100a selon un deuxième mode de réalisation. Une telle structure semiconductrice 100a se différencie de celle du premier mode de réalisation en ce que seules la deuxième et la troisième zone 120a, 130 sont ménagées dans la couche active 102a, la première zone 110a étant formée dans une couche de formation sur la deuxième zone 120a et ladite couche de formation étant réalisée dans un matériau différent de celui de la deuxième et de la troisième zone 120a, 130, la jonction semiconductrice étant sensiblement selon un surface d'orientation générale longitudinale.

Dans ce mode de réalisation, la deuxième zone 120a est une zone centrale de la structure semiconductrice 100 centrée sur l'axe de révolution B-B. La première zone 110a est une zone en contact avec la face de la couche active 102a qui est opposée à la deuxième surface 152 du support 150. La première zone 110a fait saillie de la couche active 102a.

La première zone 110a est préférentiellement adaptée pour présenter un coefficient d'absorption réduit à la longueur d'onde à détecter et/ou mesurer par sa réalisation dans un matériau semiconducteur différent de celui de la couche active 102a. Ainsi la première zone 110a peut être réalisée, pour un matériau de la couche active 102a du type CdₓHg₁₋ₓTe, dans un matériau de ce même type avec une valeur de x supérieure à celle de la couche active 102a.

En effet, pour un matériau semiconducteur du type CdₓHg₁₋ₓTe, l'augmentation de la valeur de x correspond à une ouverture de la bande interdite et donc une réduction de l'absorption dudit matériau aux grandes longueurs d'ondes.

La couche de passivation 103 est déposée, comme illustré sur la figure 4, en partie sur la couche active 102a et en partie sur la première zone 110a.

Le procédé de fabrication d'une structure semiconductrice 100a selon ce deuxième mode de réalisation comprend les étapes consistant à :
- fournir un support semiconducteur 150 comportant un substrat, une couche active 102a et une couche de formation, non illustrée, de la première zone 110a, la couche active 102a présentant une conductivité telle que les porteurs majoritaires de la couche active sont des électrons 202 et la couche de formation présentant une conductivité telle que les porteurs majoritaires sont des trous 201, la couche active 102a et la couche de formation étant préférentiellement deux matériaux différents, la couche de formation étant préférentiellement d'un matériau de plus grand gap que la couche active 102a,
- graver une partie de la couche de formation de manière à former la première zone 110a,
- déposer la couche de passivation 103 sur la couche active 102a et la première zone 110a,
- réaliser l'ouverture 105 de la couche de passivation 103 au niveau de la première zone 110a,
- déposer le plot de polarisation 104 sur la couche active 102a avec un contact entre le plot de polarisation 104 est la première zone 110a,
- réaliser une implantation ionique de la troisième zone 130 de manière à ce que la troisième zone 130 présente une conductivité telle que les porteurs majoritaires de la troisième zone sont des électrons 202, l'implantation de la troisième zone 130 étant réalisée de manière à ce qu'elle entoure la deuxième zone 120a en la délimitant.

De façon similaire à une structure semiconductrice 110 selon le premier mode de réalisation, une structure semiconductrice 110a selon ce deuxième mode de réalisation peut être intégrée à un composant semiconducteur 10 comportant une pluralité de structures semiconductrices 100c,d,e,f que ce composant semiconducteur 10 comporte ou non des système de concentration du rayonnement électromagnétique.

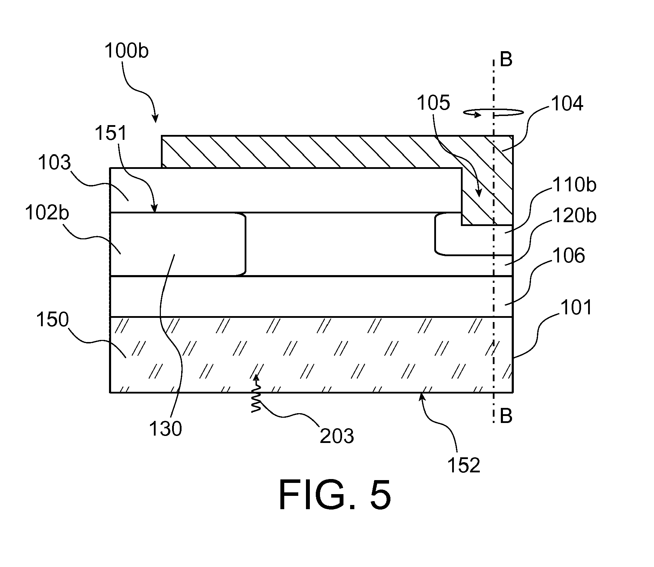

La figure 5, illustre une structure semiconductrice 100b selon un troisième mode de réalisation. Une telle structure semiconductrice 100b se différencie d'une structure semiconductrice 100 selon le premier mode de réalisation en ce que la première zone 110b est ménagée sur une partie de l'épaisseur de la couche active 102b comportant la première surface 151 du support semiconducteur 150, le reste de l'épaisseur de la couche active 102b au niveau de la première zone 110b étant une partie de la deuxième zone 120b. Cette structure semiconductrice 100b se différencie également d'une structure semiconductrice 100 selon le premier mode de réalisation en ce qu'elle comporte une couche de confinement 106 entre le substrat 101 et la couche active 102b.

Dans ce mode de réalisation la première zone 110b est une zone centrale présente sur une seule partie de l'épaisseur de la couche active 102b et comportant la surface de la couche active 102b en contact avec la couche de passivation 103. La deuxième zone 120b comporte la partie de la couche active 102b qui est comprise entre la première zone 110b et la couche de. Ainsi, la première zone 110b est contenue dans la deuxième zone 120b. La première et la seconde zone 110b, 120b sont en contact selon un plan de jonction sensiblement longitudinal et également selon une jonction latérale sur l'ensemble du pourtour de la première zone 110b. La première zone 110b est à distance de la face de la couche active 102b opposée à la première surface 151 du support semiconducteur 150.

La couche de confinement 106 est en contact avec le substrat 101 et la couche active 102b. la couche de confinement est à l'interface entre le substrat 101 et la couche active 102b. La couche de confinement 106 est en contact longitudinal avec la couche active 102b sur la face de la couche active 102b qui est opposée à la première surface 151 du support semiconducteur 150.

La couche de confinement 106 est une couche dont les propriétés sont sensiblement identiques à celles de la troisième zone 130. Ainsi la couche de confinement 106 présente une conductivité du même type que celle de la troisième zone 130 avec une concentration en porteurs majoritaires qui est du même ordre de grandeur. La couche de confinement 106 présente une épaisseur comprise entre 2 et 3 µm.

Le procédé de fabrication d'une structure semiconductrice selon ce troisième mode de réalisation se différencie de celui d'une structure semiconductrice selon le premier mode de réalisation en ce que dans l'étape de fourniture du support semiconducteur, le support est fourni avec une couche de confinement et en ce que l'étape de réalisation d'une implantation ionique de la première zone 110 dans la couche active 102 n'est réalisée que sur une partie de l'épaisseur de la couche active 102b.

Si dans ces trois modes de réalisation, le matériau semiconducteur de la couche active 102 et de la première zone 110, 110a, 110b sont choisis comme étant des matériaux semiconducteurs du type CdₓHg₁₋ₓTe, les matériaux semiconducteurs de la couche active 102 et de la première zone 110, 110a, 110b peuvent être en un autre matériau semiconducteur adapté à la longueur d'onde du rayonnement électromagnétique à détecter et/ou à mesurer, tel que l'antimoniure d'indium InSb pour l'infrarouge ou encore InAsSb et InGaAs, sans que l'on sorte de du cadre de l'invention. Selon cette possibilité, le support 150 est choisi en fonction du matériau semiconducteur dans lequel est réalisée la couche active 103, c'est-à-dire, dans le cas de l'InSb, préférentiellement un support 150 en InSb, dans le cas de InAsSb, un support 150 en GaAs et dans le cas de l'InGaAs, un support 150 en InP.

Selon une autre possibilité non illustrée et non décrite dans les modes réalisations ci-dessus, il peut également en outre être prévu une quatrième zone en contact avec la première zone 110, 110a du même type de conductivité que la première zone 110, 110a, 110b, La quatrième zone présentant une concentration en porteurs majoritaires supérieure à celle de la première zone 110, 110a, 110b.

Si dans les trois modes de réalisation décrits ci-dessus les structures semiconductrices 100, 100a sont des structures semiconductrices de révolution, la structure semiconductrice 100, 100a, 100b peut présenter une forme autre qu'une forme de révolution, telle qu'une forme cubique, ceci sans que l'on sorte du cadre de l'invention si la troisième zone 130 entoure au moins partiellement latéralement une jonction formée par une première 110, 110a, 110b et une deuxième zone 120, 120a, 120b.
[1] K. Jozwikowski, Journal of Electronic Materials, Volume 38, Number 8, pp 1666-1676,
   DOI: 10.1007/s11664-009-0752-0
[2] H.F. Schaake et Al, Journal of Electronic Materials, Volume 37, Number 9, pp 1401-1405,
   DOI: 10.1007/s11664-008-0423-6

## Revendications

1. Structure (100, 100a, 100b) semiconductrice apte à recevoir un rayonnement électromagnétique et à le transformer en un signal électrique, une telle structure (100, 100a, 100b) comportant :
- un support semiconducteur (150) présentant une première et une seconde surface (151, 152), la première surface (151) définissant un plan longitudinal,
- une première zone (110, 110a, 110b) d'un premier type de conductivité ménagée dans le support (150),
- une deuxième zone (120, 120a, 120b) d'un deuxième type de conductivité, inverse du premier type de conductivité, la deuxième zone (120, 120a, 120b) étant ménagée dans le support (150) en contact de la première zone (110, 110a, 110b) de manière former avec la première zone (110, 110a, 110b) une jonction semiconductrice,
- un moyen de limitation du courant latéral adapté pour limiter le courant de la jonction dont l'origine est latérale au plan longitudinal, ledit moyen de limitation du courant latéral entourant au moins partiellement la jonction,
la structure semiconductrice (100, 100a, 100b) étant **caractérisée en ce que** le moyen de limitation du courant latéral comporte une troisième zone (130) ménagée dans le support en contact latéral avec la deuxième zone (120, 120a, 120b), ladite troisième zone (130) étant du deuxième type de conductivité, le deuxième type de conductivité étant une conductivité dont les porteurs majoritaires sont des électrons, la troisième zone (130) présentant une concentration en porteurs majoritaires suffisante pour présenter une augmentation du gap apparent en raison d'un effet Moss Burstein.

2. Structure semiconductrice (100, 100a, 100b) selon la revendication 1, dans laquelle la troisième zone (130) entoure la jonction.

3. Structure semiconductrice (100, 100a, 100b) selon la revendication 1 ou 2, dans laquelle il est en outre prévu une quatrième zone en contact avec la première zone (110, 110a, 110b) du même type de conductivité que la première zone (110, 110a, 110b), la quatrième zone présentant une concentration en porteurs majoritaires supérieure à celle de la première zone (110, 110a, 110b).

4. Structure semiconductrice (100, 100b) selon l'une quelconque des précédentes revendications, dans laquelle la deuxième zone (120, 120b) entoure la première zone (110, 110b), la troisième zone (130) entourant la deuxième zone (120, 120b).

5. Structure semiconductrice (100a, 100b) selon l'une quelconque des revendications 1 à 4, dans laquelle la première zone (110a, 110b) et la deuxième zone (120a, 120b) sont en contact selon un plan de jonction sensiblement longitudinal.

6. Structure semiconductrice (100b) selon la revendication 5, dans laquelle les première, deuxième et troisième zones (110b, 120b, 130) sont ménagées dans une couche (102b) du support qui est dite active, la couche active (102b) comportant la première surface (151) du support semiconducteur (150) et la première zone (110b) étant à distance de la face de la couche active (102b) opposée à la première surface (151) du support semiconducteur (150), la structure semiconductrice (100b) comportant en outre une couche (106) dite de confinement, ménagée dans le support semiconducteur (150) en contact longitudinal avec la couche active (102) sur une face de la couche active (102) opposée à la première surface (151) du support semiconducteur (150), ladite couche de confinement (106) présentant le deuxième type de conductivité, la couche de confinement (106) présentant une concentration en porteurs majoritaires suffisante pour présenter une augmentation du gap apparent en raison d'un effet Moss Burstein.

7. Structure semiconductrice (100,100a, 100b) selon l'une quelconque des précédentes revendications, dans laquelle la structure comprend un moyen de polarisation électrique de la première zone, ledit moyen de polarisation étant ménagé sur la première surface, la deuxième surface étant adaptée pour recevoir le rayonnement électromagnétique.

8. Structure semiconductrice (100, 100a, 100b) selon l'une quelconque des revendications précédentes dans laquelle au moins la première et la deuxième zone sont réalisées dans un matériau semiconducteur différent de celui de l'autre zone de la première et la deuxième zone de manière à ce que la structure forme une hétérostructure.

9. Structure semiconductrice (100, 100a, 100b) selon l'une quelconque des revendications précédentes, dans laquelle au moins l'une des zones (110, 110a, 110b, 120, 120a, 120b, 130) de la première, la deuxième et la troisième zone (110, 110a, 110b, 120, 120a, 120b, 130) est réalisée dans un matériau semiconducteur sélectionné parmi l'InSb et les semiconducteurs du type InAsₓSb₁₋ₓ, InₓGa₁₋ₓAs et CdₓHg₁₋ₓTe, avec x compris entre 0 et 1.

10. Composant semiconducteur (10) comportant un support semiconducteur (150) sur lequel sont ménagées une pluralité de structures semiconductrices (100,c,d,e,f), le composant semiconducteur (10) étant **caractérisé en ce que** au moins une des structures semiconductrices (100a,b,e,f) est une structure semiconductrice selon l'une quelconque des revendications 1 à 9.

11. Composant semiconducteur (10) selon la revendication 10, dans lequel toutes les structures semiconductrices (100c,d, e, f) sont des structures semiconductrices (100, 100a) selon l'une des revendications 1 à 9, les troisièmes zones (130c,d,e,f) des structures (100c,d,e,f) étant en contact les unes avec les autres.

12. Composant semiconducteur (10) selon la revendication 11, dans lequel il est en outre prévu un moyen de concentration de rayonnement adapté pour concentrer la lumière reçu par le composant semiconducteur (10) sur la jonction semiconductrice, ledit moyen étant préférentiellement agencé dans le composant semiconduteur (10) en regard de la première surface du support (150)semiconducteur.

13. Procédé de fabrication d'une structure semiconductrice (100, 100a, 100b), **caractérisé en ce qu'**il est adapté pour la fabrication d'une structure semiconductrice (100, 100a, 100b) selon l'une des revendications 1 à 9, ledit procédé comprenant les étapes consistant à :
- fournir un support (150) semiconducteur,
- former la première zone (110, 110a, 110b) d'un premier type de conductivité dans le support (150) semiconducteur,
- former la deuxième zone (120, 120a, 120b) d'un second type de conductivité, dont les porteurs majoritaires sont des électrons (202), dans le support en contact avec la première zone (110, 110a, 110b) de manière à former une jonction semiconductrice,
- former la troisième zone (130) du second type de conductivité, en contact latéral avec la deuxième zone (120, 120a, 120b), la concentration de ladite troisième zone (130) étant suffisante pour présenter un effet Moss Burstein, ladite troisième zone (130) entourant au moins partiellement la jonction semiconductrice.

14. Procédé de fabrication selon la revendication 13, dans lequel le procédé est adapté pour réaliser une structure semiconductrice (100) selon la revendication 4 ou la revendication 4 en combinaison avec l'une des revendications 6 à 9, les étapes de formation de la première et de la deuxième zone (110, 110b, 120, 120b) sont réalisées simultanément en formant la première zone (110, 110b) dans une couche du support présentant la concentration du type de la deuxième zone (120, 120b).

15. Procédé selon la revendication 13, dans lequel le procédé est adapté pour la formation d'une structure semiconductrice (100a) selon la revendication 5 ou la revendication 5 en combinaison avec l'une des revendications 6 à 9, l'étape de formation de la première couche (110a) comportant une étape de gravure d'une couche de formation de la première couche (110a) en contact avec la deuxième couche (120a) de manière à former la jonction semiconductrice.

## Patentansprüche

1. Halbleiterstruktur (100, 100a, 100b), die geeignet ist, eine elektromagnetische Strahlung aufzunehmen und diese in ein elektrisches Signal umzuwandeln, wobei eine derartige Struktur (100, 100a, 100b) aufweist:
einen Halbleiterträger (150), der eine erste und eine zweite Fläche (151, 152) aufweist, wobei die erste Fläche (151) eine Längsebene definiert,
eine erste Zone (110, 110a, 110b) eines ersten Leitfähigkeitstyps, die in dem Träger (150) angeordnet ist,
eine zweite Zone (120, 120a, 120b) eines zweiten Leitfähigkeitstyps, die umgekehrt zum ersten Leitfähigkeitstyp ist, wobei die zweite Zone (120, 120a, 120b) in dem Träger (150) in Kontakt mit der ersten Zone (110, 110a, 110b) angeordnet ist, derart, dass mit der ersten Zone (110, 110a, 110b) ein Halbleiterübergang gebildet wird,
eine Einrichtung zur Begrenzung des seitlichen Stroms, die ausgebildet ist, um den Strom des Übergangs zu begrenzen, dessen Ursprung seitlich zur Längsebene ist, wobei die Einrichtung zur Begrenzung des seitlichen Stroms den Übergang zumindest teilweise umgibt,
wobei die Halbleiterstruktur (100, 100a, 100b) **dadurch gekennzeichnet ist, dass** die Einrichtung zur Begrenzung des seitlichen Stroms eine dritte Zone (130) aufweist, die in dem Träger in seitlichem Kontakt mit der zweiten Zone (120, 120a, 120b) angeordnet ist, wobei die dritte Zone (130) vom zweiten Leitfähigkeitstyp ist, wobei der zweite Leitfähigkeitstyp eine Leitfähigkeit ist, bei der die Majoritätsträger Elektronen sind, und die dritte Zone (130) eine Konzentration an Majoritätsträgern aufweist, die ausreicht, um eine Zunahme der scheinbaren Bandlücke darzubieten, und zwar aufgrund eines Moss-Burstein-Effekts.

2. Halbleiterstruktur (100, 100a, 100b) nach Anspruch 1, bei der die dritte Zone (130) den Übergang umgibt.

3. Halbleiterstruktur (100, 100a, 100b) nach Anspruch 1 oder 2, bei der weiter eine vierte Zone vorgesehen ist, die sich in Kontakt mit der ersten Zone (110, 110a, 110b) befindet, und zwar vom gleichen Leitfähigkeitstyp wie die erste Zone (110, 110a, 110b), wobei die vierte Zone eine höhere Konzentration an Majoritätsträgern als die erste Zone (110, 110a, 110b) aufweist.

4. Halbleiterstruktur (100, 100b) nach einem der vorhergehenden Ansprüche, wobei die zweite Zone (120, 120b) die erste Zone (110, 110b) umgibt, und wobei die dritte Zone (130) die zweite Zone (120, 120b) umgibt.

5. Halbleiterstruktur (100a, 100b) nach einem der Ansprüche 1 bis 4, bei der die erste Zone (110a, 110b) und die zweite Zone (120a, 120b) entlang einer im Wesentlichen in Längsrichtung verlaufenden Übergangsebene in Kontakt sind.

6. Halbleiterstruktur (100b) nach Anspruch 5, bei der die erste, die zweite und die dritte Zone (110b, 120b, 130) in einer Schicht (102b) des Trägers angeordnet sind, die als aktiv bezeichnet wird, wobei die aktive Schicht (102b) eine erste Fläche (151) des Halbleiterträgers (150) aufweist und die erste Zone (110b) beabstandet zu der Seite der aktiven Schicht (102b) angeordnet ist, welche zu der ersten Fläche (151) des Halbleiterträgers (150) entgegengesetzt ist, und die Halbleiterstruktur (100b) weiter eine Schicht (106) aufweist, die als Begrenzungsschicht bezeichnet wird und die in dem Halbleiterträger (150) in Längsrichtungskontakt mit der aktiven Schicht (102) ist, und zwar auf einer Seite der aktiven Schicht (102), die zu der ersten Fläche (151) des Halbleiterträgers (150) entgegengesetzt ist, wobei die Begrenzungsschicht (106) einen zweiten Leitfähigkeitstyp aufweist, und wobei die Begrenzungsschicht (106) eine Konzentration an Majoritätsträgern aufweist, die ausreicht, um eine Zunahme der scheinbaren Bandlücke darzubieten, und zwar aufgrund eines Moss-Burstein-Effekts.

7. Halbleiterstruktur (100, 100a, 100b) nach einem der vorhergehenden Ansprüche, bei der die Struktur eine Einrichtung zur elektrischen Polarisation der ersten Zone aufweist, wobei die Einrichtung zur Polarisation auf der ersten Fläche angeordnet ist, wobei die zweite Fläche ausgebildet ist, um die elektromagnetische Strahlung aufzunehmen.

8. Halbleiterstruktur (100, 100a, 100b) nach einem der vorhergehenden Ansprüche, bei der zumindest die erste und die zweite Zone aus einem Halbleitermaterial realisiert sind, das unterschiedlich zu dem der anderen Zone von der ersten und der zweiten Zone ist, derart, dass die Struktur eine Heterostruktur bildet.

9. Halbleiterstruktur (100, 100a, 100b) nach einem der vorhergehenden Ansprüche, bei der zumindest eine von den folgenden Zonen (110, 110a, 110b, 120, 120a, 120b, 130), und zwar von der ersten, der zweiten und der dritten Zone (110, 110a, 110b, 120, 120a, 120b, 130), aus einem Halbleitermaterial realisiert ist, das ausgewählt ist aus InSb und den Halbleitern vom Typ InAsₓSb₁₋ₓ, InₓGa₁₋ₓAs und CdₓHg₁₋ₓTe, wobei x zwischen 0 und 1 liegt.

10. Halbleiterbauteil (10), das einen Halbleiterträger (150) aufweist, auf dem eine Mehrzahl von Halbleiterstrukturen (100c, d, e, f) angeordnet sind, wobei das Halbleiterbauteil (10) **dadurch gekennzeichnet ist, dass** mindestens eine der Halbleiterstrukturen (100a, b, e, f) eine Halbleiterstruktur nach einem der Ansprüche 1 bis 9 ist.

11. Halbleiterbauteil (10) nach Anspruch 10, bei dem die Halbleiterstrukturen (100c, d, e, f) Halbleiterstrukturen (100, 100a) nach einem der Ansprüche 1 bis 9 sind, wobei die dritten Zonen (130c, d, e, f) der Strukturen (100c, d, e, f) miteinander in Kontakt sind.

12. Halbleiterbauteil (10) nach Anspruch 11, bei dem weiter eine Einrichtung zur Konzentration von Strahlung vorgesehen ist, die ausgebildet ist, um das vom Halbleiterbauteil (10) empfangene Licht auf dem Halbleiterübergang zu konzentrieren, wobei die Einrichtung vorzugsweise in dem Halbleiterbauteil (10) gegenüber der ersten Fläche des Halbleiterträgers (150) angeordnet ist.

13. Verfahren zur Herstellung einer Halbleiterstruktur (100, 100a, 100b), **dadurch gekennzeichnet, dass** es zur Herstellung einer Halbleiterstruktur (100, 100a, 100b) nach einem der Ansprüche 1 bis 9 geeignet ist, wobei das Verfahren die folgenden Schritte umfasst:
Bereitstellen eines Halbleiterträgers (150),
Ausbilden der ersten Zone (110, 110a, 110b) eines ersten Leitfähigkeitstyps in dem Halbleiterträger (150),
Ausbilden der zweiten Zone (120, 120a, 120b) eines zweiten Leitfähigkeitstyps, bei dem die Majoritätsträger Elektronen (202) sind, und zwar in dem Träger in Kontakt mit der ersten Zone (110, 110a, 110b), derart, dass ein Halbleiterübergang gebildet wird.
Ausbilden der dritten Zone (130) des zweiten Leitfähigkeitstyps in seitlichem Kontakt mit der zweiten Zone (120, 120a, 120b), wobei die Konzentration der dritten Zone (130) ausreicht, um einen Moss-Burstein-Effekt darzubieten, wobei die dritte Zone (130) den Halbleiterübergang zumindest teilweise umgibt.

14. Verfahren zur Herstellung nach Anspruch 13, wobei das Verfahren geeignet ist, eine Halbleiterstruktur (100) nach Anspruch 4, oder nach Anspruch 4 in Kombination mit einem der Ansprüche 6 bis 9 zu realisieren, wobei die Schritte zur Ausbildung der ersten und der zweiten Zone (110, 110b, 120, 120b) gleichzeitig ausgeführt werden, wobei dabei die erste Zone (110, 110b) in einer Trägerschicht ausgebildet wird, welche die Konzentration des Typs der zweiten Zone (120, 120b) aufweist.

15. Verfahren nach Anspruch 13, wobei das Verfahren geeignet ist zur Ausbildung einer Halbleiterstruktur (100a) nach Anspruch 5, oder nach Anspruch 5 in Kombination mit einem der Ansprüche 6 bis 9, wobei der Schritt zur Ausbildung der ersten Schicht (100a) einen Schritt zum Ätzen der Schicht zur Ausbildung der ersten Schicht (110a) umfasst, die sich in Kontakt mit der zweiten Schicht (120a) befindet, derart, dass der Halbleiterübergang gebildet wird.

## Claims

1. Semiconducting structure (100, 100a, 100b) capable of receiving electromagnetic radiation and transforming it into an electric signal, such a semiconducting structure (100, 100a, 100b) comprising:
- a semiconducting support (150) with a first and a second surface (151, 152), the first surface (151) defining a longitudinal plane,
- a first zone (110, 110a, 110b) with a first type of conductivity formed in the support (150),
- a second zone (120, 120a, 120b) with a second type of conductivity that is opposite of the first type of conductivity, the second zone (120, 120a, 120b) being formed in the support (150) in contact with the first zone (110, 110a, 110b) so as to form a semiconducting junction with the first zone (110, 110a, 110b),
- a means of limiting the lateral current adapted to limit the junction current that originates laterally to the longitudinal plane, said means of limiting the lateral current at least partially surrounding the junction,
the semiconducting structure (100, 100a, 100b) being **characterised in that** the means of limiting the lateral current comprises a third zone (130) formed in the support in lateral contact with the second zone (120, 120a, 120b), said third zone (130) having the second type of conductivity, the second type of conductivity being a conductivity for which majority carriers are electrons, the third zone (130) having a sufficient concentration of majority carriers to have an increase in the apparent gap due to a Moss-Burstein effect.

2. Semiconducting structure (100, 100a, 100b) according to claim 1, in which the third zone (130) surrounds the junction.

3. Semiconducting structure (100, 100a, 100b) according to claim 1 or 2, in which a fourth zone in contact with the first zone (110, 110a, 110b) with the same type of conductivity as the first zone (110, 110a, 110b), may also be provided, the fourth zone having a greater concentration of majority carriers than the first zone (110, 110a, 110b).

4. Semiconducting structure (100, 100b) according to any one of the previous claims, in which the second zone (120, 120b) surrounds the first zone (110, 110b), the third zone (130) surrounding the second zone (120, 120b).

5. Semiconducting structure (100a, 100b) according to any one of claims 1 to 4, in which the first zone (110a, 110b) and the second zone (120a, 120b) are in contact on an approximately longitudinal junction plane.

6. Semiconducting structure (100b) according to claim 5, in which the first, second and third zones (110b, 120b, 130) are formed in a support layer (102b) said active layer, the active layer (102b) comprising the first surface (151) of the semiconducting support (150) and the first zone (110b) being at a distance from the face of the active layer (102b) opposite the first surface (151) of the semiconducting support (150), the semiconducting structure (100b) also comprising a so-called confinement layer (106), formed in the semiconducting support (150) in longitudinal contact with the active layer (102) on a face of the active layer (102) opposite the first surface (151) of the semiconducting support (150), said confinement layer (106) having the second type of conductivity, the confinement layer (106) having a sufficient concentration of majority carriers to have an increase in the apparent gap due to a Moss-Burstein effect.

7. Semiconducting structure (100,100a, 100b) according to any one of the previous claims, in which the structure comprises a means of electric polarisation of the first zone, said polarisation means being formed on the first surface, the second surface being adapted to receive electromagnetic radiation.

8. Semiconducting structure (100, 100a, 100b) according to any one of the previous claims, in which at least the first and the second zone are made from a semiconducting material different from the material used for the other zone among the first and second zones such that the structure forms a heterostructure.

9. Semiconducting structure (100, 100a, 100b) according to any one of the previous claims, in which at least one of the zones (110, 110a, 110b, 120, 120a, 120b, 130) among the first, second and third zones (110, 110a, 110b, 120, 120a, 120b, 130) is made from a semiconducting material selected from among InSb and semiconductors of the InAsₓSb₁₋ₓ, InₓGa₁₋ₓAs and CdₓHg₁₋ₓTe type where x is between 0 and 1.

10. Semiconducting component (10) comprising a semiconducting support (150) on which a plurality of semiconducting structures (100,c,d,e,f) is formed, the semiconducting component (10) being **characterised in that** at least one of the semiconducting structures (100a,b,e,f) is a semiconducting structure according to any one of claims 1 to 9.

11. Semiconducting component (10) according to claim 10, in which all semiconducting structures (100c,d, e, f) are semiconducting structures (100, 100a) according to one of claims 1 to 9, the third zones (130c,d,e,f) of the structures (100c,d,e,f) being in contact with each other.

12. Semiconducting component (10) according to claim 11, in which a means of concentrating electromagnetic radiation adapted to concentrate the light received by the semiconducting component (10) on the semiconducting junction is also provided, said means preferably being formed in the semiconducting component (10) facing the first surface of the semiconducting support (150).

13. Process for fabricating a semiconducting structure (100, 100a, 100b), **characterised in that** it is adapted for fabrication of a semiconducting structure (100, 100a, 100b) according to one of claims 1 to 9, said process comprising the following steps:
- provide a semiconducting support (150),
- form the first zone (110, 110a, 110b) with a first type of conductivity in the semiconducting support (150),
- form the second zone (120, 120a, 120b) with a second type of conductivity, of which the majority carriers are electrons (202), in the support in contact with the first zone (110, 110a, 110b) so as to form a semiconducting junction,
- form the third zone (130) with the second type of conductivity, in lateral contact with the second zone (120, 120a, 120b), the concentration of said third zone (130) being sufficient to have a Moss Burstein effect, said third zone (130) at least partially surrounding the semiconducting junction.

14. Fabrication process according to claim 13, in which the process is adapted to make a semiconducting structure (100) according to claim 4 or claim 4 combined with one of claims 6 to 9, steps for formation of the first and second zones (110, 110b, 120, 120b) are made simultaneously by forming the first zone (110, 110b) in a support layer with the concentration of the type of the second zone (120, 120b).

15. Process according to claim 13, in which the process is adapted to form a semiconducting structure (100a) according to claim 5 or claim 5 combined with one of claims 6 to 9, the step in which the first layer (110a) is formed including a step to etch a formation layer of the first layer (110a) in contact with the second layer (120a) so as to form the semiconducting junction.
